(19) Europäisches Patentamt
European Patent Office
Office européen des brevets

(11) Publication number: 0 297 583 A2

(12) # EUROPEAN PATENT APPLICATION

(21) Application number: 88110486.3

(51) Int. Cl.⁴: G03C 1/68 , G03F 7/10

(22) Date of filing: 30.06.88

(30) Priority: 03.07.87 JP 165530/87
27.06.88 JP 159777/88

(43) Date of publication of application:
04.01.89 Bulletin 89/01

(84) Designated Contracting States:
DE FR GB

(71) Applicant: CANON KABUSHIKI KAISHA
30-2, Shimomaruko 3-chome
Ota-ku Tokyo 146(JP)

(72) Inventor: Fukui, Tetsuro
1458-4, Kajigaya Miyamae-ku
Kawasaki-shi Kanagawa-ken(JP)
Inventor: Arahara, Kozo
No. 601, Eimu Hirama 23-1, Tajiri-cho
Nakahara-ku
Kawasaki-shi Kanagawa-ken(JP)
Inventor: Fukumoto, Hiroshi
12-5, Saginuma 1-chome Miyamae-ku
Kawasaki-shi Kanagawa-ken(JP)
Inventor: Takasu, Yoshio
1-7-503, Toyogaoka 3-chome
Tama-shi Tokyo(JP)

(74) Representative: Struif, Bernward, Dipl.-Chem.
Dr. et al
Patentanwaltsbüro Tiedtke, Bühling, Kinne
Grupe, Pellmann, Grams, Struif,Winter, Roth
Bavariaring 4
D-8000 München 2(DE)

(54) **Photosensitive material and image forming method by use thereof.**

(57) A photosensitive material comprises at least a polymer precursor, a photosensitive polymerization-controlling agent and a polymerization initiator. An image forming method comprises applying light image exposure on the photosensitive material to form a latent image with a photosensitive polymerization-controlling agent, and thereafter subjecting the photosensitive material to heat treatment to form an image through difference in polymerization degree of the polymer precursor between the light image exposed portion of and the unexposed portion of the photosensitive material. The photosensitive material can further contain a polymerization-inhibiting promotor of the photosensitive polymerization-controlling agent.

EP 0 297 583 A2

# Photosensitive Material and Image Forming Method by Use Thereof

## Background of the Invention

### Field of the Invention

This invention relates to a photosensitive material for forming an image by forming a latent image by photoenergy and thereafter amplifying the latent image by heat energy, and an image forming method by use thereof.

### Related Background Art

Energies to be used for formation of images or recording may include light energy, acoustic energy, electrical energy, magnetic energy, heat energy, energy of particle rays (electron beam, X ray) or chemical energy, and among them light energy, electrical energy, heat energy or a combination of these has been frequently used.

For example, the combination of light energy and chemical energy is used for silver salt photography and diazo copying paper. Also, the combination of light energy and electrical energy is used for the electrophotographic system.

Further, as the system utilizing heat energy, there are heat sensitive recording paper and transfer recording paper, while as the system utilizing electric energy, there have been known an electrostatic recording paper, an electrothermal recording paper ,an electrosensitive recording paper, etc.

Among the image forming methods as described above, the silver salt method may be employed as the method for obtaining an image of high resolution. However, in the silver salt method, cumbersome developing and fixing processing by use of liquid agents or drying processing of image (print) are required.

Recently, by marked progress of themal head, the market of heat-sensitive recording paper has been expanded, but since resolution of such a recording paper depends on the number of picture elements of the thermal head, in obtaining of an image of high resolution there is a certain limit.

Accordingly, as a new image forming method free from the problems as described above, namely the novel image forming method utilizing light energy and heat energy, there has been known the method in which dry (thermal) polymerization reaction is caused to occur with the photosensitive reaction of silver halide as the trigger to form an image comprising a polymer; as disclosed in Japanese Patent Application Laid-open No. 61-69062.

Also, there is the method as disclosed in Japanese Patent Application Laid- open No. 62-70836, in which a latent image is formed by the silver nucleus formed from the silver halide by image exposure, and a reducing agent is converted to an oxidized product having polymerization-inhibiting ability different from said reducing agent under heating of the reducing agent by utilizing the catalytic action of the silver nucleus, thereby creating difference in polymerization-inhibiting ability between the reducing agent and the oxidized product formed, simultaneously with causing thermal polymerization reaction to occur utilizing a thermal polymerization initiator to form a polymer image corresponding to the difference in polymerization-inhibiting ability.

However, in this method, since the formation reaction of the compound having polymerization-inhibiting ability (oxidized prduct) and thermal polymerization reaction occur simultaneously under heating, thermal polymerization reaction cannot proceed sufficiently, whereby there occurs such drawback that no good contrast can be obtained in the polymer image, etc.

## Summary of the Invention

An object of the present invention is to provide a photosensitive material capable of giving an image of high resolution without applying cumbersome chemical treatment by use of a liquid agent and an image forming method by use thereof.

Further, an object of the present invention is to provide a photosensitive material capable of taking out

easily good contrast in the polymer image by heat treatment in an image forming method by utilizing light energy and heat energy, and an image forming method by use thereof.

The above objects of the present invention can be accomplished by the present invention as specified below.

More specifically, the present invention provides a photosensitive material, comprising at least a polymer precursor. a photosensitive polymerization-controlling agent and a polymerization initiator.

The present invention also provides a photosensitive material, comprising at least a polymer precursor, a photosensitive polymerization-controlling agent, a polymerization initiator and a polymerization-inhibiting promotor of said photosensitive polymerization-controlling agent.

The present invention also provides an image forming method, which comprises applying light image exposure on a photosensitive material containing at least a polymer precursor, a photosensitive polymerization-controlling agent and a polymerization initiator to form a latent image with a photosensitive polymerization-controlling agent, and thereafter subjecting the photosensitive material to heat treatment to form an image through difference in polymerization degree of the polymer precursor between the light exposed portion of and the unexposed portion of the photosensitive material.

The present invention also provides an image forming method, which comprises applying light image exposure on a photosensitive material containing at least a polymer precursor, a photosensitive polymerization-controlling agent, a polymerization initiator and a polymerization-inhibiting promotor of said photosensitive polymerization-controlling agent to form a latent image with a photosensitive polymerization-controlling agent, and thereafter subjecting the photosensitive material to heat treatment to form an image through difference in polymerization degree of the polymer precursor between the light image exposed portion of and the unexposed portion of the photosensitive material.

## Detailed Description of the Preferred Embodiments

The photosensitive material of the present invention contains at least a polymer precursor, a photosensitive polymerization-controlling agent and a polymerization initiator, and forms a latent image with the photosensitive-controlling agent by lightenergy and forms a polymerized image based on the above latent image by heat energy. Also, in addition to the above constituents, a sensitizing dye and a polymerization-inhibiting promotor may be also contained.

In the following, the photosensitive material of the present invention is described in more detail.

The polymer precursor to be used in the present invention refers to a monomer containing a reactive vinyl group, an oligomer containing a reactive vinyl group or a polymer containing a reactive vinyl group, and it is required to have at least one reactive vinyl group in one molecule. Examples of the reactive vinyl group may include a styrene type vinyl group, an acrylic acid type vinyl group, a methacrylic acid vinyl group, an allyl type vinyl group, a vinyl ether and additionally a substituted or non-substituted vinyl group having polymerizability such as an ester type vinyl group, for example, vinyl acetate.

Specific examples of the polymer precursor satisfying such requirements are as below.

For example, there may be included monovalent monomers such as styrene, methylstyrene, chlorostyrene, bromostyrene, methoxystyrene, dimethylaminostyrene, cyanostyrene, nitrostyrene, hydroxystyrene, aminostyrene, carboxystyrene, acrylic acid, methyl acrylate, ethyl acrylate, cyclohexyl acrylate, acrylamide, methacrylic acid, methyl methacrylate, ethyl methacrylate, propyl methacrylate. butyl methacrylate, phenyl methacrylate, cyclohexyl methacrylate, vinyl pyridine, N-vinylpyrrolidone, N-vinylimidazole, 2-vinylimidazole, N-methyl-2-vinylimidazole, propyl vinyl ether, butyl vinyl ether, isobutyl vinyl ether, $\beta$-chloroethyl vinyl ether, phenyl vinyl ether, p-methylphenyl vinyl ether, p-chlorophenyl vinyl ether, etc.; divalent monomers such as divinylbenzene, distyryl oxalate, distyryl malonate, distryl succinate. distyryl glutarate, distyryl adipate, distyryl maleate, distyryl fumarate, distyryl $\beta,\beta$-dimethylglutarate, distyryl 2-bromoglutarate, distyryl $\alpha,\alpha'$-dichloroglutarate, distyryl terephthalate, di(2-acryloyloxyethyl) oxalate, di(2-acryloyloxy-1 or 2-methylethyl) oxalate, di(2-acryloyloxyethyl) malonate, di(2-acryloyloxy-1 or 2-methylethyl) malonate, di(2-acryloyloxyethyl) succinate, di(2-acryloyloxyethyl) glutarate, di(2-acryloyloxyethyl) adipate, di-(2 acryloyloxyethyl) maleate, di(2-acryloylexyethyl) fumarate, di(2-acryloyloxyethyl) $\beta$, $\beta$-dimethylglutarate, ethylenediacrylamide, propylene diacrylamdie, 1,4-phenylenediacrylamide, 1,4-bis(2-acryloyloxyethoxy) benzene, 1,4-bis(2-acryloyloxy-1 or 2-methylethoxy) benzene, 1,4-bis(acryloyloxyethoxy)cyclohexane, 1,4-bis(acryloyloxymethylethoxy)cyclohexane, 1,4-bis(acryloyloxyethoxycarboxamide)benzene, 1,4-bis-(acryloyloxymethylethoxycarboxamide)benzene, 1,4-bis(acryloyloxymethylethoxycarboxamide)cyclohexane, bis(acryloyloxyethoxycarbamoylcyclohexyl)methane, di(2-methacryloyloxyethl) oxalate, di(2-methacryloyloxy-1 or 2-methylethyl) oxalate, di(2-methacryloyloxyethyl) malonate, di(2-methacryloyloxy-1 or

2-methylethyl) malonate, di(2-methacryloyloxyethyl) succinate, di(2-methacryloyloxy 1-or 2-methylethyl) succinate, di(2-methacryloyloxyethyl) glutarate, di″-methacryloyloxyethyl) adipate, di(2-methacryloyloxyethyl) maleate, di(2-methacryloyloxyethyl) fumarate, di(2-methacryloyloxyethyl) β, β-dimethylglutarate, 1,4-bis(2-methacryloyloxyethoxy) benzene, 1,4-bis(methacryloyloxyethoxy)cylohexane, acryloyloxyethoxyethyl vinyl ether, etc.; trivalent monomers such as pentaerythritol triacrylate, pentaerythritol trimethacrylate, ether of pentaerythritol with three molecules of p-hydroxystyrene cyanuric acid triacrylate, cyanuric acid trimethacrylate, 1,1,1-trimethylolpropane triacrylate, 1,1,1-trimethylolpropane trimethacrylate, cyanuric acid tri(ethylacrylate), 1,1,1-trimethylolpropane tri(ethylacrylate), cyanuric acid tri(ethyl vinyl ether), a condensate of 1,1,1-trimethylolpropane tri(toluenediisocyanate) with hydroxyethyl acrylate, a condensate of 1,1,1-trimethylolpropane tri(hexanediisocyanate) with p-hydroxystyrene; tetrvalent monomers such as ethylene tetraacrylamide, propylene tetraacrylamide, etc.; and additionally a polymer precursor having a reactive double bond remained at the terminal end of an oligomer or a polymer or a polymer precursor having a reactive double bond attached to the side chain of an oligomer or a polymer.

Next, the photosensitive polymerization-controlling agent is a substance playing a switching function in polymerization reaction, which undergoes structrual change or chemical reaction by exposure to exhibit polymerization-inhibiting ability. In the present invention, the photosensitive polymerization controlling agent, for example, a hydroxy aromatic compound is subjected to photo-oxidation by light exposure to form a quinone derivative.

Here, the difference between the presence of the hydroxy derivative and the quinone derivative has the property of changing the polymerization rate of the polymerizable monomer employed, and therefore a polymerized pattern is obtained by application of a heat treatment as the developing step after light exposure. That is, for the hydroxy derivative, a positive image is obtained when a monomer having polymerization-inhibiting action is selected, while a negative image is obtained in the opposite case.

Also, as the polymerization-inhibiting promotor of the photosensitive polymerization-controlling agent, metal salts such as photosensitive silver salts, non-photosensitive silver salts, silver halides having fogcenters, copper salts and monovalent mercury salts, etc. may be also contained. The polymerization-inhibiting promotor promotes decomposition or oxidation of the photosensitive-controlling agent at the lightexposed portion, and also enhances polymerization-inhibiting ability of the photosensitive-controlling agent during heating, thereby making greater the difference in polymerization rate (contrast) of the polymer precursor at the exposed portion and the unexposed portion. The polymerization-inhibiting promotor may be used at a ratio of 0.5 to 200 parts by weight, more preferably 2 to 100 parts by weight, per 10 parts by weight of the photosensitive polymerization-controlling agent.

Specific examples of the hydroxy aromatic compound which is the photosensitive polymerization-controlling agent to be used in the present invention may include preferably polycyclic aromatic compounds such as 1,4-dihydroxynaphthalene, 4-methoxy-1-naphthol, 2-methyl-4-methoxy-1-naphthol, 4-ethoxy-1-naphthol, 1,5-dihydroxynaphthalene, 4,4′-dimethoxy-1,1′-dihydroxy-2,2′-binaphthyl, 1,1′-dihydroxy-2,2-binaphthyl, 1-methoxy-5-hydroxyanthracene, 1-ethoxy-5-hydroxyanthracene, 1,3-dihydroxyanthracene, hydroxyanthracene, 4-cyclohexyloxy-1-naphthol, 2-methoxy-1-naphthol, 4-methoxy-7-methyl-1-naphthol, 4,4′-dihydroxy-1,1′-binaphthyl, 3,3′-dimethoxy-4,4′-dihydroxy-1,1′-binaphthyl, 1,1′-dihydroxy-4,4′-dimethyl-2,2′-binaphtyl, 1,1′-dihydroxy-4,4′-diethoxy-2,2′-binaphthyl, 2,2′-dihydroxy-1,1′-binaphthyl, 1,1-dihydroxy-2,2′-dimethyl-4,4′-binaphthyl, 1,1′-dihydroxy-4,4′-bis(diethylamino)-2,2′-binaphthyl, 2,2′-bis(1-hydroxy-4-methoxy-2-naphthyl)propane, 2,2-bis(1-hydroxy-4-ethoxy-2-naphthyl)propane, etc. in aspect of sensitivity or sensitizing effect.

Other than the hydroxy aromatic compounds as set forth above, as the photosensitive polymerization-controlling agent to be used in the present invention, aromatic diazo compounds can be included. Specific preferable examples of such aromatic diazo compounds may include:

p-(N,N-diethylamino)phenyldiazonium chloride, p(-N-benzyl-N-ethylamino)phenyldiazonium chloride, p-(N-phenylamino)phenyldiazoniumsulfonate, p-(N-ethyl-N-hydroxyethylamino)phenyldiazonium tetrafluoroborate, 2-methoxy-4-nitrophenyldiazonium chloride, 2-methoxynaphthyl-1-diazonium chloride, 4-methoxynaphthyl-1-diazonium chloride, 4-ethoxy-2-methylnaphthyl-1-diazoniumsulfonate, 2-hydroxynaphthyl-1-diazonium chloride, 4 pyrazolino-2,6-diethoxyphenyldiazonium chloride, 4-p-(tolylthio)-2,6-diethoxyphenyldiazonium tetraphenylborate, etc. The aromatic diazo compounds as mentioned above can form various hydroxy derivatives and alkoxy derivatives by light exposure to create difference in polymerization rate between the exposed portion and the unexposed portion.

These photosensitive polymerizationcontrolling agent may be used in an amount of 0.l to 30 parts by weight, more preferably 1 to 15 parts by weight based on 100 parts by weight of the polymer precursor, and 1 to 1000 parts by weight, more preferably 10 to 300 parts by weight based on 100 parts by weight of the polymerization initiator.

Next, as the polymerization initiator to be used in the present invention, known thermal polymerization initiators can be used, and these may include azo type initiators and peroxide type initiators.

First, the azo type initiator refers to an organic compound having at least one nitrogen-nitrogen double bond, as exemplified by azobisisobutyronitrile, azobiscyclohexanecarbonitrile, azobismethylthenethylcarbonitrile, azobis sec-amylonitrile, azobisphenylethane, azobiscyclohexylpropylnitrile, azobismethylchloroethane, tritylazobenzene, phenylazoisobutyronitrile, 9-(p-nitrophenylazo)-9-phenylfluorene, etc.

As the peroxide type initiator, almost all of the organic compounds having at least one oxygen-oxygen bond in the molecule are included. For example, there may be incldued methyl ethyl ketone peroxide, cyclohexanone peroxide, 3,3,5-trimethylcyclohexanone peroxide, methylcyclohexanone peroxide, acetyl acetone peroxide, 1,1-bis(tert- butylperoxy)-3,3,5-trimethylcyclohexane, 1-1-bis(tert-butylperoxy)-cyclohexane, n-butyl-4,4-bis(tert-butylperoxy)valerate, 2,2-bis(tert-butylperoxy)butane, tert-butyl hydroperoxide, cumene hydroperoxide, diisopropylpenpine hydroperoxide, p-menthane hydroperoxide, 2,5-dimethylhexane-2, 5-dihydroperoxide, 1,1,3,3-tetramethylbutyl hydroperoxide, di-tert-butylperoxide, tert-butylcumylperoxide, dicumylperoxide, $\alpha,\alpha'$-bis(tert-butylperoxyisopropyl)benzene, 2,5-dimethyl-2,5-di(tert-butylperoxy)hexane, 2,5-dimethyl-2,5-di(tert-butylperoxy)hexyne-3, acetylperoxide, isobutyrylperoxide, octanoylperoxide, decanoylperoxide, lauroylperoxide, 3,5,5-trimethylhexanoylperoxide, peroxysuccinic acid, benzoyl peroxide, 2,4-dichlorobenzoylperoxide, m-toluoylperoxide, diisopropylperoxy dicarbonate, di-2-ethylhexylperoxy dicarbonate, di-n-propylperoxy dicarbonate, di-2-ethoxyethylperoxy dicarbonate, dimethoxyisopropylperoxy dicarbonate, di-(3-methyl-3-methoxybutyl)peroxy dicarbonate, tert-butylperoxyacetate, tert-butyl peroxyisobutyrate, tert-butyl peroxyneodecanoate, tert-butyl peroxypivalate, tert-butyl peroxyoctanoate, tert-butyl peroxy-3,5,5-trimethylhexanoate, tert-butyl peroxylaurate, tert-butyl peroxybenzoate, di-tert-butyl diperoxyisophthalate, 2,5-dimethyl-2,5-di(benzoylperoxy)hexane, tert-butyl peroxymaleate, tert-butyl peroxyisopropylcarbonate, etc.

The polymer precursor, the photosensitive polymerization-controlling agent and the polymerization initiator must be contained as the essential components in an image forming layer.

For forming the image forming layer, the above essential components are dissolved in a solvent together with a binder conveniently used, applied and dried on a support such as metal, plastic, paper, etc., or when the binder itself can hold the strength, the above essential components may be also contained in the film or the sheet formed the binder.

The image forming layer may have a thickness of 0.5 µm to 0.5 mm, preferably 1 µm to 50 µm.

The shape of the support may be plane, cylindrical, roll-like, etc. and is not particularly limited thereto.

Preferable binders to be used in the preseent invention can be selected from a wide variety of resins. Specific examples of the binders may include cellulose esters such as nitrocellulose, cellulose phosphate, cellulose sulfate, cellulose acetate, cellulose propionate, cellulose butyrate, cellulose myristate, cellulose palmitate, cellulose acetate propionate, cellulose acetate butyrate, etc.; oellulose ethers such as methyl cellulose, ethyl cellulose, propyl cellulose, butyl cellulose, etc.; vinyl resins such as polystyrene, polyvinyl chloride, polyvinyl acetate, polyvinyl butyral, polyvinyl acetal, polyvinyl alcohol, polyvinyl pyrrolidone, etc.; copolymer resins such as styrene-butadiene copolymer, styrene-acrylonitrile copolymer, styrene-butadiene-acrylonitrile copolymer, vinyl chloride-vinyl acetate copolymer, etc.; acrylic resins such as polymethyl methacrylate, polybutyl acrylate, polyacrylic acid, polymethacrylic acid, polyacrylamide, polyacrylonitrile, etc.; polyesters such as polyethylene terephthalate, etc.; polyarylate resins such as (4,4'-isopropylidenediphenylene/1,4-cyclohexylenedimethylenecarbonate) copolymer, poly(ethylenedioxy-3,3'-phenylenethiocarbonate), (4,4'-isopropylidenediphenylenecarbonate/terephthalate) copolymer, poly(4,4'-isopropylidenediphenylenecarbonate), poly(4,4'-sec-butylidenediphenylenecarbonate), poly(4,4'-isopropylidenediphenylenecarbonate/oxyethylene) blockpolymer, etc.; or polyamides: polyimides: epoxy resins; phenol resins; polyolefins such as polyethylene, polypropylene, chlorinated polyethylene; and so on.

The binder may be used at a proportion of 1000 parts by weight or less, more preferably 10 to 300 parts by weight, based on 100 parts by weight of the polymer precursor.

Also, in the present invention, it is possible to similtaneously use a dye exhibiting a sensitizing effect and or a colorant for visualization of polymerized pattern. For example, the dyes exhibiting a sensitizing effect include cyanine dyes, melocyanine dyes, rhodamine dyes, etc.

As the cyanine dye, the comounds represented by the following formula (I) may be employed.

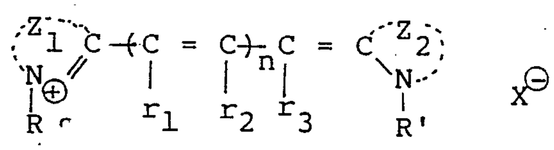

(I)

In the above formula (I), R, R′, $r_1$, $r_2$, $r_3$ may be the same or different, and selected from the group consisting of a hydrogen atom, a halogen atom, and a substituted or unsubstituted alkyl, alkenyl, alkynyl, cycloalkyl, aryl, aralkyl or alaryl group. Z1 and Z2 each represent a group of atoms necessary for forming a skelton of oxazole, thiazole, selenazole, benzoxazole, benzothiazole, benzoselenazole, benzimidazole, naphthoxazole, naphthothiazole, naphthoselenazole, quinoline or indoline together with C=N-R, C=N-R′, and may also have a substituent. n is an integer of 0 to 3. $X^{\ominus}$ represents an anion, with proviso that no $X^{\ominus}$ exists when R or R′ represents a carboxylic acid anion or a sulfonic acid anion group.

As the melocyanine dye, the compounds represened by the following formula (II) may be employed:

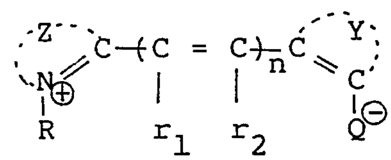

(II)

In the above formula (II), R, $r_1$, $r_2$, Z, n are respectively the same as those in the formula (I), y represents a group of atoms necessary for forming rhodamine, two coupled rhodanine rings stabilized by its a resonance structure, oxazolidinone, oxazolinone together with C=C-Q, with proviso that Q represents oxygen atom or sulfur atom.

As the rhodamine dye, the compounds represented by the following formula (III) may be employed.

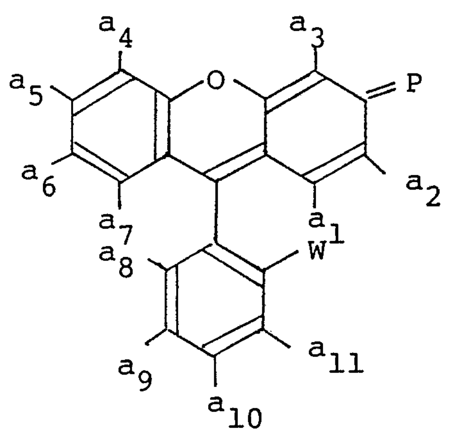

(III)

In the above formula (III), P is a di-substituted amino group or oxygen atom, $a_1$ through $a_{11}$ are each selected from the group consisting of a hydrogen atom, a halogen atom, a hydroxyl group, an alkali metal salt of a hydroxyl group, an alkyl group, a di-substituted amino group, a carboxylic acid group, an alkali metal salt of a carboxylic acid group, a sulfonic acid group and an alkali metal salt of a sulfonic acid group. W represents carboxylic acid or sulfonic acid, or alternatively may be in the form of anions thereof. The di-substituted amino group may also form a cyclic comound with the adjacent substituent.

The sensitizing dye as described above may be employed at a ratio of 0.01 to 50 parts by weight, more preferably 0.1 to 5 parts by weight, based on 10 parts by weight of the photosensitive polymerization-controlling agent.

Next, the image forming method of the present invention is a method in which an image is formed by forming a latent image with a photosensitive polymerization-controlling agent by applying light image exposure with a light energy on the photosensitive material as described above, and then applying heat treatment, thereby forming an image through the difference in polymerization degree of the polymer precursor between the light image exposed portion of and the unexposed portion of the photosensitive material. In other words, according to the method of the present invention, there occurs a difference in polymerization-inhibiting ability of the photosensitive polymerization-controlling agent by lightexposure, and

by the subsequent heat treatment, there is formed a polymer image corresponding to the difference in the above polymerization-inhibiting ability. Thus, the method of the present invention is characterized in using a photosensitive material containing a photosensitive polymerization-controlling agent, and the photosensitive polymerization-controlling agent is a substance which plays a switching function of polymerization reaction as described, and can exhibit polymerization-inhibiting ability by causing structural change or chemical reaction to occur by exposure.

In the present invention, the switching function difference before and after exposure of the photosensitive polymerization-controlling agent is permitted to remain as a latent image after exposure, and heat treatment is applied thereon to effect development and fixation with amplification.

To describe further, the photosensitive polymerization-controlling agent refers to a compound which acts on the polymer precursor as described above to control its polymerization rate, and what effects such action are decomposed products, oxides, etc. formed by irradiation with active electromagnetic waves such as UV-ray, visible light, IR-ray and others.

As the method for developing the polymer image thus prepared (e.g., bringing it into an visible image), there are an etching method, a peel apart method, a toning or inking treatment and the like.

As described above, the present invention gives rise to the difference in polymerization-inhibiting ability of the photosensitive polymerization-controlling agent by exposure and forms a polymer image corresponding to the above difference in polymerization-inhibiting ability by subsequent heat treatment, and therefore sufficient difference in contrast between the exposed portion and the unexposed portion can be achieved easily, and additionaly the present invention has such an effect that an image of high resolution can be obtained without application of cumbersome chemical treatment by use of a liquid agent.

The image forming method of the present invention can be used also as a substitute for recording method or plate making method as a matter of course.

The present invention is described in more detail referring to the following Examples. Further, the term "parts" used in Examples is based on weight.

Example 1

An amount of 100 parts of an epoxy acrylate (trade name V5502, produced Dainippon Ink Co.) as a polymer precursor, 10 parts of a 1,4-dihydroxynaphthalene aa a photosensitive polymerization-controlling agent and 7 parts of azobisisobutyronitrile as a thermal polymerization initiator were dissolved in 100 parts of methyl ethyl ketone, and the solution obtained was applied on an aluminum plate with a thickness of 0.2 mm to a dried film thickness of 5 µm.

Then, after the coated film was formed by drying in air in a dark room, a polyethylene terephthalate (PET) film was superposed thereon and image exposure was effected thereon by use of a UV-ray irradiator (trade name UVC-2135, produced by Ushio Denk Co.) for 10 seconds, followed by thermal polymerization on a hot plate heated to 100 °C.

The unexposed portion was cured within 40 seconds to become turbid, but the exposed portion W as not cured even when heated for 90 seconds. When the coated film was dipped in methyl ethyl ketone, the exposed portion was dissolved to give a sharp image on the aluminum plate surface.

Example 2

A polymer image was formed on a photosensitive material similar to that used in Example 1 in a similar manner to in Example 1. When it was allowed to go between rollers heated to 60°C under a pressure of $25kg/cm^2$ and then a PET film was peeled therefrom, simultaneously a light unexposed portion of the photosensitive material was peeled of, whereby a clear image was formed on the surface of an aluminum plate.

Example 3

The convex-concave image obtained in Example 1 or 2 as a plating plate was attached to a printing machine (manufactured by Gesterner A.G.). Then, according to offset inking, recording was performed with respect to a hundred sheets of paper, providing clear images in the respect papers.

Example 4

A solution of 100 parts of the epoxy acrylate (as described above), 10 parts of 4-methoxy-1-naphthol as a photosensitive polymerization-controlling agent, 5 parts of azobisisobutyronitrile and 20 parts of polyvinyl butyral dissolved in 100 parts of methyl ethyl ketone was applied on an aluminum plate in the same manner as described in Example 1. Following thereafter the same procedure as in Example 1, image exposure was effected for 10 seconds, followed by heating. The unexposed portion was cured within 30 seconds, but the exposed portion not cured even when heated for 90 seconds to give a sharp image on the aluminum plate surface.

Example 5

The experiment was conducted in the same manner as in Example 4, except for replacing the polymer precursor with pentaerythritol triacrylate. The unexposed portion was cured within 40 seconds, and the exposed portion, when heating was further continued, became cured and turbid after 110 seconds.

Example 6

The experiment was conducted in the same manner as in Example 4 except for replacing the polymer precursor with
bis(acryloyloxyethoxycarboxyamidocyclohexyl)methane and the thermal polymerization initiator with benzoyl peroxide. As compared with the unexposed portion which was cured within 30 seconds, the exposed portion was not cured even after 120 seconds.

Example 7

A solution of 40 parts of trimethylolpropane triacrylate as a polymer precursor, 2 parts of 4-methoxy-1-naphthol as a photosensitive polymerization-controlling agent, 4 parts of dicumyl peroxide as a thermal polymerization initiator and 20 parts of polymethyl methacrylate dissolved in 60 parts of dichloroethane was applied on a polyethylene terephthalate (PET) film to a dried film thickness of 5 $\mu$m to prepare a photosensitive paper. Separately, 2 parts of behenic acid were dissolved in 30 parts of toluene and 30 parts of n-butanol, and then 5 parts of silver behenate and 2 parts of polyvinyl butyral were added to the solution, followed by dispersing by means of a homomixer at 5000 rpm for 5 minutes, and the resultant dispersion was applied on a PET film to a dried film thickness of 6 $\mu$m to prepare an amplifying paper.

Through a positive film superposed on the above photosensitive paper, exposure was effected by a UV-ray irradiator for 10 seconds, and then with the photosensitive paper superposed on the coated surface of the amplifying paper, heating was effected at 100 °C for 30 seconds.

After the PET film on the amplifying paper side was peeled off, etching was effected in an ethanol bath, whereby the exposed portion was dissolved and removed to give a sharp positive image on the PET film. Even when the heating time was made 150 seconds, the exposed portion was not cured to give a similar image.

Example 8

To 60 parts of toluene and 60 parts of n-butanol were added 6 parts of silver behenate and the mixture was dispersed by a homomixer at 5000 rpm for 5 minutes, and subsequently in the resultant dispersion were dissolved 20 parts of trimethylolpropane triacrylate as a polymer precursor, 1 part of 4-methoxy-1-naphthol as a photosensitive polymerization-controlling agent, 2 parts of dicumyl peroxide as a thermal polymerization initiator and 5 parts of polyvinyl butyral, and the resulting solution was applied on an aluminum plate to a dried film thickness of 4 $\mu$m to prepare a photosensitive paper.

Through a PET film superposed on the above photosensitive paper, and further a positive mask superposed thereon, exposure was effected for 10 seconds a UV-ray irradiator for 10 seconds, followed by

heating at 100 °C for 25 seconds.

After the PET film was peeled off, etching in an ethanol bath allowed the exposed portion to be dissolved and removed to give a sharp positive image. That is, the same effect as the development accelerating effect as in Example 5 was obtained by using silver behenate.

Example 9

A polymer image was formed on a photosensitive material similar to that used in Example 8 in a similar manner to in Example 8. When it was allowed to go between rollers heated to 60°C under a pressure of 25kg/cm$^2$ and then a PET film was peeled therefrom, simultaneously a light unexposed portion of the photosensitive material was peeled off, whereby a clear image was formed on the surface of an aluminum plate.

Example 10

The uneven image obtained in Example 8 or 9 as a plating plate was attached to a printing machine (manufactureed byGestener A.G.). Then, according to offset inking, recording was performed with respect to each of a hundred sheets of paper, providing clear images in the respective papers.

Example 11

While 500 parts of hot water of 60 °C were containing 5 parts of gelatin and 10.2 parts of potassium bromide dissolved therein were stirred, 100 parts of hot water containing 15 parts of silver nitrate dissolved therein were added over 30 minutes to prepare an emulsion. The emulsion was cooled to 5 °C to form a gel, washed with 1000 parts of pure water and subjected to exposure on its whole surface. Then, gelatin was decomposed with a gelatin decomposing enzyme, and the silver bromide was separated by filtration and dried.

The silver bromide having fog centers thus obtained (4 parts) was dispersed in 50 parts of toluene and 50 part of isopropanol, and subsequently 25 parts of trimethylolpropane triacrylate as a precursor, 1 part of 4-methoxy-1-naphthol as the photosensitive polymerization-controlling agent, 3 parts of azobiscyclohexanecarbonitrile as a thermal initiator and 5 parts of polymethyl methacrylate were dissolved therein, and the resulting solution was applied on an aluminum plate to a dried film thickness of 4 µm to prepare a photosensitive paper.

Through a PET film superposed on the above photosensitive paper, and further a positive mask superposed thereon, exposure was effected by a UV-ray irradiator for 10 seconds, followed by heating at 110 °C for 10 seconds. After the PET film was peeled off, etching in an ethanol bath gave the unexposed portion remained as a polymerized image. When, the heating temperature was made 100 °C, the polymerized image was obtained by heating within 20 seconds.

Example 12

A solution of 100 parts of an epoxy acrylate (trade name V5502, produced by Dainippon Ink), 10 parts of 2,2′-dihydroxy-1,1′-binaphthyl, 7 parts of azobisisobutyronitrile dissolved in 100 parts of methyl ethyl ketone was applied on an aluminum substrate to a dried film thickness of 5 µm. Through a PET film superposed on the coating, image exposure was effected for 10 seconds, followed by heating on a hot plate of 100 °C. The unexposed portion was cured within 30 seconds, but the exposed portion was not cured even when heated for 90 seconds.

Example 13

Example 5 was repeated except that 10 parts of 4-methoxy-1-naphthol were replaced with 15 parts of p-(N-ethyl-N-hydroxyethylamino)phenyldiazonium tetrafluoroborate. The unexposed portion was cured within 40 seconds, but the exposed portion was not cured until 70 seconds.

Example 14

A photosensitive solution was prepared by dissolving 5 parts of p-(N-ethyl-N-hydroxyethylamino)phenyldiazolinium tetrafluoroborate and 10 parts of ethyl cellulose in 50 parts of a 1/1 solvent mixture of ethyl acetate and ethanol, and the solution was applied on a PET film to a dried film thickness of 7 µm to obtain a photosensitive paper.

Separately, 3 parts of silver behenate was dispersed in 50 parts of a 1/1 solvent mixture of xylene/n-butanol. Subsequently, 50 parts of pentaerythritol triacrylate, 10 parts of polymethyl methacrylate, 0.4 parts of Oil Blue (produced by Sumitomo Kagaku) and 2.5 parts of azobisisobutyronitrile were dissolved. The solution was applied on an aluminum substrate to a dried film thickness of 5 µm to obtain an image forming member. After the image exposure was effected on a photosensitive paper for 10 seconds, the coated surface of the image forming member was brought into contact therewith and heating was effected on a hot plate of 100 °C. The unexposed portion was cured within 20 seconds, but the exposed portion was not cured until 70 seconds.

Example 15

The image forming member as obtained Example 14 and the coated surface of the photosensitive paper were superposed on each other, and image exposure was effected from the PET film side for 10 seconds. Subsequently, heating was effected on a hot plate of 100 °C. The unexposed portion was cured within 20 seconds but the exposed portion not cured until 70 seconds.

Example 16

100 parts of epoxy acrylate, 0.5 part of erythrocin, 10 parts of 4-ethoxy-1-naphthol, 7 parts of azobisisobutyronitrile and 20 parts of polyvinyl butyral were dissolved in 200 parts of a 1/1 solvent mixture of toluene/isopropanol. The solution was applied on a PET film to a dried film thickness of 6 µm. Subsequently, a layer of a polyvinyl alcool (PVA) with a thickness of 2 µm was provided. The image forming member thus obtained was subjected to imagewise exposure to the light from a ultra-high pressure mercury lamp through a cut filter (Y-46, produced by Toshiba Glass) for 10 seconds. Then, heating was effected on a hot plate of 120 °C. The unexposed portion was cured within 20 seconds, but the exposed portion not cured.

Example 17

An image forming member was prepared and evaluated in the same manner as in Example 16 except for substituting 0.8 part of 3,3′-diethyl-2,2-thiacarbocyanine iodide for 0.5 part of erythrocin . After heated on a hot plate of 120 oC for 20 seconds, the PVA layer was removed by washing with water, followed etching in an ethanol bath, whereby the image at the unexposed portion remained on the PET.

Comparative example

In 10 parts of ethanol were dispersed and dissolved 0.2 part of AgBrI, 0.5 part of silver behenate and 0.3 par of phenidone to prepare liquid A.

Separately, in 10 parts of methyl ethyl ketone were dissolved 1.0 part of polymethyl methacrylate, 2.7 part of epoxy acrylate (V5502, produced by Dainippon Ink Co.) and 0.26 parts of azobisisobutyronitrile to prepre liquid B. Then, liquid A and liquid B were well mixed and the mixture was applied on a PET film to a dried film thickness of 5 µm, followed further by provision of a PVA layer with a thickness of 2 µm.

On the image forming member thus obtained, a negative image was superposed and image exposure was effected for 10 seconds, followed by heating on a hot plate controlled to 120 °C for 60 seconds.

After removal of the pVA layer by washing with water, all the image forming layer was dissolved and removed from the PET substrate by rinsing with methyl ethyl ketone. When the heating treatment was extended to 80 seconds, all the surface was polymerized to give no dissolved portion.

## Claims

1. A photosensitive material, comprising at least a polymer precursor, a photosensitive polymerization-controlling agent and a polymerization initiator.

2. A photosensitive material according to Claim 1, wherein said polymerization-controlling agent is a substance which is changed by exposure to light to a substance with greater polymerization inhibiting action with respect to the polymer precursor.

3. A photosensitive material according to Claim 1, wherein said polymerization-controlling agent is a polycyclic aromatic compound or an aromatic diazo compound.

4. A photosensitive material according to Claim 1, wherein said polymer precursor is at least one of a monomer containing a reactive vinyl group, an oligomer containing reactive vinyl group and a polymer containing a reactive vinyl group.

5. A photosensitive material according to Claim 1, wherein said polymerization initiator is an azo type initiator or a peroxide type initiator.

6. A photosensitive material according to Claim 1, containing further a sensitizing dye.

7. A photosensitive material according to Claim 6, wherein said sensitizing dye is a cyanine dye, a melocyanine dye or a rhodamine dye.

8. A photosensitive material, comprising at least a polymer precursor, a photosensitive polymerization-controlling agent, a polymerization initiator and a polymerization-inhibiting promotor of said photosensitive polymerization-controlling agent.

9. A photosensitive material according to Claim 8, wherein said polymerization-controlling agent is a substance which is changed by exposure to light to another substance with greater polymerization inhibiting action respect to to the polymer precursor.

10. A photosensitive material according to Claim 8, wherein said polymerization-controlling agent is a polycyclic aromatic compound or an aromatic diazo compound.

11. A photosensitive material according to Claim 8, wherein the polymerization-inhibiting promotor of said photosensitive polymerization-controlling agent is a copper salt, a monovalent mercury salt, silver halide having a fog center, a non-photosensitive silver salt or a photosensitive silver salt.

12. A photosensitive material according to Claim 8, wherein said polymer precursor is at least one of a monomer containing a reactive vinyl group, an oligomer containing a reactive vinyl group and a polymer containing a reactive vinyl group.

13. A photosensitive material according to Claim 8, wherein said polymerization initiator is an azo type initiator or a peroxide type initiator.

14. A photosensitive material according to Claim 8, containing further a sensitizing dye.

15. A photosensitive material according to Claim 14, wherein said sensitizing dye is a cyanine dye, a melocyanine dye or a rhodamine dye.

16. An image forming method, which comprises applying light image exposure on a photosensitive material containing at least a polymer precursor, a photosensitive polymerization-controlling agent and a polymerization initiator to form a latent image with a photosensitive polymerization-controlling agent, and thereafter subjecting the photosensitive material to heat treatment to form an image through difference in polymerization degree of the polymer precursor between the light image exposed portion of and the unexposed portion of the photosensitive material.

17. An image forming method according to Claim 16, wherein said polymerization-controlling agent is a substance which is changed by exposure to light to another substance with greater polymerization inhibiting action with respect to the polymer precursor.

18. An image forming method according to Claim 16, wherein said polymerization-controlling agent is a polycyclic aromatic compound or an aromatic diazo compound.

19. An image forming method according to Claim 16, wherein said polymer precursor is at least one of a monomer containing a reactive vinyl group, an oligomer containing a reactive vinyl group and a polymer containing a reactive vinyl group.

20. An image forming method according to Claim 16, wherein said polymerization initiator is an azo type initiator or a peroxide type initiator.

21. An image forming method according to Claim 16, containing further a sensitizing dye.

22. An image forming method according to Claim 21, wherein said sensitizing dye is a cyanine dye, a melocyanine dye or a rhodamine dye.

23. An image forming method according to Claim 16, further comprising subjecting said image to developing treatment.

24. An image forming method, which comprises applying light image exposure on a photosensitive material containing at least a polymer precursor, a photosensitive polymerization-controlling agent, a polymerization initiator and a polymerization-inhibiting promotor of said photosensitive polymerization-controlling agent to form a latent image with a photosensitive polymerization-controlling agent, and thereafter subjecting the photosensitive material to heat treatment to form an image through difference in polymerization degree of the polymer precursor between the light image exposed portion of and the unexposed portion of the photosensitive material.

25. An image forming method according to Claim 24, wherein said polymerization-controlling agent is a substance which is changed by exposure to light to another substance with greater polymerization inhibiting action with respect to the polymer precursor.

26. An image forming method according to Claim 24, wherein said polymerization-controlling agent is a polycyclic aromatic compound or an aromatic diazo compound.

27. An image forming method according to Claim 24, wherein the polymerization-inhibiting promotor is a copper salt, a monovalent mercury salt, silver halide having a fog center, a non-photosensitive silver salt or a photosensitive silver salt.

28. An image forming method according to Claim 24, wherein said polymer precursor is at least one of a monomer containing a reactive vinyl group, an oligomer containing a reactive vinyl group and a polymer containing a reactive vinyl group.

29. An image forming method according to Claim 24, wherein said polymerization initiator is an azo type initiator or a peroxide type initiator.

30. An image forming method according to Claim 24, containing further a sensitizing dye.

31. An image forming method according to Claim 30, wherein said sensitizing dye is a cyanine dye, a melocyanine dye or a rhodamine dye.

32. An image forming method according to Claim 24, further comprising subjecting said image to developing treatment.